(19) Europäisches Patentamt
European Patent Office
Office européen des brevets

(11) **EP 4 745 609 A1**

(12) **EUROPEAN PATENT APPLICATION**

(43) Date of publication:
20.05.2026 Bulletin 2026/21

(21) Application number: 24212876.7

(22) Date of filing: 14.11.2024

(51) International Patent Classification (IPC):
*G01R 33/3815* (2006.01)

(52) Cooperative Patent Classification (CPC):
G01R 33/3815

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(71) Applicant: Koninklijke Philips N.V.
5656 AE Eindhoven (NL)

(72) Inventors:
• VERNICKEL, Peter
Eindhoven (NL)
• LIPS, Oliver
Eindhoven (NL)
• FORTHMANN, Peter
5656AG Eindhoven (NL)

(74) Representative: Philips Intellectual Property &
Standards
High Tech Campus 52
5656 AG Eindhoven (NL)

(54) **POWER MANAGEMENT OF MAGNETIC RESONANCE IMAGING MAGNETS**

(57) Disclosed herein is a power management system (100) for a magnetic resonance imaging magnet (102) comprising a power supply (104) configured for powering the magnetic resonance imaging magnet. The power management system further comprises an electrical power storage system (112). The power management system further comprises an energy recovery system (106) configured for discharging electrical power from the magnetic resonance imaging magnet and storing the electrical power in the electrical power storage system when the power supply ceases powering the magnetic resonance imaging magnet. The power management system is further configured for at least partially powering the magnetic resonance magnet using the electrical power storage system.

Fig. 1

**Description**

TECHNICAL FIELD

The invention relates to magnetic resonance imaging, in particular to the powering magnetic resonance imaging magnets.

BACKGROUND

A large static magnetic field is used by Magnetic Resonance Imaging (MRI) scanners to align the nuclear spins of atoms as part of the procedure for producing images within the body of a subject. This large static magnetic field is referred to as the B0 field or the main magnetic field. In MRI, the atomic spins are manipulated using gradient magnetic fields and radio frequency (RF) pulses.

MRI magnets are powerful superconducting magnets that generate the B0 field. Traditional MRI magnets rely on liquid helium as a coolant to maintain the extremely low temperatures required for superconductivity. However, advancements in technology have led to the development of sealed MRI magnets using very little helium for cooling or even helium-free magnets, which use conductive cooling. Both approaches eliminate the dependency on continually replenishing the magnet with liquid helium.

SUMMARY

The invention provides for a power management system for a magnetic resonance imaging magnet, a magnetic resonance imaging system, a method of operating the magnetic resonance imaging magnet, and a computer program in the independent claims. Embodiments are given in the dependent claims.

In one aspect a power management system for a magnetic resonance imaging magnet is disclosed. The power management system comprises a power supply configured for powering a magnetic resonance imaging magnet. The power management system further comprises an electrical power storage system. The power management system further comprises an energy recovery system configured for discharging electrical power from the magnetic resonance imaging magnet and storing the electrical power in the electrical power storage system. The power management system is further configured for at least partially powering the power supply using the electrical power storage system. In another aspect, a magnetic resonance imaging magnet comprising the power management system is disclosed.

In another aspect, a magnetic resonance imaging system comprising the magnetic resonance imaging magnet is disclosed.

In another aspect, a method of operating the magnetic resonance imaging magnet is disclosed. The method comprises disabling powering of the magnetic resonance imaging magnet with the power supply. The method further comprises discharging the magnetic resonance imaging system using the energy recovery system to charge the electrical power storage system. The method further comprises ramping up charging of the magnetic resonance imaging magnet using the power supply at least partially using stored electrical power in the electrical power storage system.

In another aspect, a computer program comprising machine-executable instructions for execution by a computational system and configured for controlling the magnetic resonance imaging magnet is disclosed. Execution of the machine-executable instructions causes the computational system to control the energy recovery system to discharge the magnetic resonance imaging system to charge the electrical power storage system. Execution of the machine-executable instructions further causes the computational system to control the power supply to ramp up charging of the magnetic resonance imaging magnet at least partially using stored electrical power in the electrical power storage system.

Features described with respect to method embodiments are applicable and are contemplated also for corresponding system embodiments, with similar benefits.

This Summary is provided to introduce a selection of concepts in a simplified form that are further described below in the Detailed Description. This Summary is not intended to identify key features or essential features of the claimed subject matter, nor is it intended to limit the scope of the claimed subject matter. A more extensive presentation of features, details, utilities, and advantages of the system embodiment and method embodiments, as defined in the claims, is provided in the following written description of various embodiments of the disclosure and illustrated in the accompanying drawings.

BRIEF DESCRIPTION OF THE DRAWINGS

In the following preferred embodiments of the invention will be described, by way of example only, and with reference to the drawings in which:

Fig. 1 illustrates an example of a power management system for a magnetic resonance imaging magnet.
Fig. 2 illustrates some design considerations when designing a power management system.
Fig. 3 illustrates some further design considerations when designing a power management system.
Fig. 4 illustrates some further design considerations when designing a power management system.
Fig. 5 illustrates an example of a magnetic resonance imaging system.
Fig. 6 shows a flow chart which illustrates a method of using the power management system with a magnetic resonance imaging magnet.

DESCRIPTION OF EMBODIMENTS

For the purposes of promoting and understanding the principles of the present disclosure, reference will now be made to the embodiments illustrated in the drawings, and specific language will be used to describe the same. It is nevertheless understood that no limitation to the scope of the disclosure is intended. Any alteration and further modifications to the described devices, systems, and methods, and any further application of the principles of the present disclosure are fully contemplated and included within the present disclosure as would normally occur to one skilled in the art to which the disclosure relates. In particular, it is fully contemplated that the features, components, and/or steps described with respect to one embodiment may be combined with the features, components, and/or steps described with respect to other embodiments of the present disclosure. For the sake of brevity, however, the numerous iterations of these combinations will not be described separately. Features described in relation to a system, may be implemented in a computer-implemented method and/or in a computer program product, in a corresponding manner.

Like numbered elements in these figures are either equivalent elements or perform the same function. Elements which have been discussed previously will not necessarily be discussed in later figures if the function is equivalent.

In an example, there is a power management system for a magnetic resonance imaging magnet that comprises a power supply configured for powering a magnetic resonance imaging magnet. The power management system further comprises an electrical power storage system. The power management system further comprises an energy recovery system configured for discharging electrical power from the magnetic resonance imaging magnet and storing electrical power in the electrical power storage system. The power management system is further configured for at least partially powering the power supply using the electrical power storage system. For example, the electrical power storage system provides electrical power to the power supply for ramping up or maintaining the magnetic field of the magnetic resonance imaging magnet. This example may be beneficial because it may provide for a means of recovering electrical power from a magnetic resonance imaging magnet when it is powered or ramped down.

In another example, the power supply is configured for continually powering a driven magnetic resonance imaging magnet. The energy recovery system is configured for discharging electrical power from the magnetic resonance imaging magnet and storing electrical power in the electrical power storage system when the power supply ceases powering the magnetic resonance imaging magnet. In driven magnets the power supply continually supplies current to maintain the magnetic field in the magnetic resonance imaging magnet. The power supply supplies the full current (I), which may be hundreds of amperes. However, due to the low resistivity (R) of the superconducting magnet, the power ($I^2R$) is comparably small.

Since the power supply is continually operating, it may therefore be beneficial to not have the magnetic field maintained when the magnetic resonance imaging system is not being used. The power management system may provide for a cost-effective means of powering down and then powering up a driven magnetic resonance imaging magnet.

In another example the driven magnetic resonance imaging magnet is a sealed magnetic resonance imaging magnet. A sealed magnetic resonance imaging magnet as used here encompasses magnets that use a cryocooler or pulse-tube technology to recycle liquid Helium during the cooling of the superconducting coils of the magnetic resonance imaging magnet. In these magnets, a cryocooler may be used to maintain temperatures that enable superconducting level without significant helium loss.

In another example, the energy recovery system comprises a controlled discharge path configured for regulating the discharge of the electrical power. The energy recovery system further comprises a DC-to-DC converter system configured for charging the electrical power storage system using the regulated electric power. This example may be beneficial because it may provide for a cost effective and energy efficient means of implementing the energy recovery system.

In another example the energy recovery system is configured to discharge the magnetic resonance imaging magnet within 120 seconds or within 60 seconds using the controlled discharge path and the DC-to-DC converter system. The use of the controlled discharge path and the DC-to-DC converter system enable this rapid discharge of the magnetic resonance imaging system. This may for example be beneficial in situations where there needs to be an emergency discharge of the magnetic resonance imaging magnet. Also using the controlled discharge path and the DC-to-DC converter system provide a means of dumping energy into the electrical power storage system and avoiding heating of the magnetic resonance imaging magnet. This may for example enable the power management system to be used to power up a magnetic resonance imaging magnet more rapidly or sooner after the field has been brought down.

In another example, the DC-to-DC converter system comprises an automotive regenerative braking or kinetic energy recovery system (KERS) DC-to-DC converter system. The amount of energy in a car which is travelling at highway speeds is approximately the same amount of energy contained in a typical clinical magnetic resonance imaging magnetic field. The time to slow the car to a stop from highway speeds is also comparable to the time to power down the magnetic resonance imaging magnet. From a power and time standpoint, the needs of an automotive DC-to-DC converter match the needs of a DC-to-DC converter for the MRI energy power recovery system.

The DC-to-DC converters typically used for automotive locations may therefore be used for the DC-to-DC converter system for the power management system. This example enables the off the use shelf of these components for a different use and since they are available in mass production for automotive applications they may be available at a relatively cost effective price.

In another example, the DC-to-DC converter is bidirectional and is configured for at least partially powering the power supply using the electrical power storage system. Using a bidirectional DC-to-DC converter may be beneficial as this reduces the number of components and thereby the cost of implementing the power management system.

In another example, the control discharge path is implemented using any one of the following: MOSFETs, IGBTs, SiC transistors, GaAs transistors, gallium nitride transistors, and combinations thereof. The use of any of these components may be beneficial because they provide several advantages. These devices provide for efficient switching and enable the energy efficient conversion of energy. Another advantage is that they may provide for overcurrent and overvoltage protection as well as having thermally stable properties.

In another example, the electrical power storage system comprises a flywheel energy storage system. This, for example may provide for an effective means of putting a lot of energy very rapidly into a flywheel. This may for example prevent overheating of a magnetic resonance imaging magnet that is being discharged. The flywheel energy storage system is preferably an automotive flywheel energy storage system. These are for example available for the construction of racecars. In some examples, the automotive flywheel energy storage system may be used off the shelf and implemented into the electrical power storage system.

In another example, the electrical power storage system is configured to transfer electrical power to an electrical grid. The electrical power storage system could in some examples be used to store and/or retrieve electrical power from the electrical grid. This may have the advantage that the need to store electrical power locally is reduced or eliminated. This functionality could also be used in conjunction with other examples that include a battery, flywheel or supercapacitor. Power could for example be deposited into a supercapacitor and then if it will not be used in the near future it could be returned to the electrical power grid to avoid losing the power over time.

In another example, the electrical power storage system comprises a supercapacitor energy storage system. The supercapacitor energy storage system preferably comprises at least one Lithium ion capacitor. The use of supercapacitors enables the very rapid storing of electrical power relatively efficiently. This may for example enable a larger amount of energy to be transferred than if it was into a comparable battery. This may for example be useful in performing emergency ramp downs or quenches of a magnet.

In another example, the electrical power storage system comprises a battery system. The use of a battery or battery system in the electrical power storage system may be beneficial because it may provide for efficient long-term storage of electrical power.

In another example, the battery storage system comprises at least one lithium ion battery, at least one lead acid battery, at least one sodium battery, and combinations thereof.

In another aspect, there is a magnetic resonance imaging magnet. The magnetic resonance imaging magnet comprises an example of the power management system. This combination may be beneficial because it may provide for a magnetic resonance imaging magnet that may be ramped up or ramped down with increased electrical efficiency.

In another example, there is a magnetic resonance imaging system that comprises the magnetic resonance imaging magnet. This may be beneficial because it may provide for a magnetic resonance imaging system with reduced power usage.

In another example, there is a method of operating a magnetic resonance imaging magnet. The method comprises discharging the magnetic resonance imaging magnet using the energy recovery system to charge the electrical power system. The method further comprises ramping up of the magnetic resonance imaging magnet using the power supply at least partially using the stored electrical power in the electrical power storage system. In this example, the magnetic resonance imaging magnet is first discharged and used to store electrical power in the electrical power storage system. During the ramping up of the magnetic resonance imaging magnet some of this energy may be recovered and then used for powering the magnetic resonance imaging magnet.

In another example, the power supply is configured for continually powering a driven magnetic resonance imaging magnet. The method further comprises disabling power of the driven magnetic resonance imaging magnet with the power supply before discharging the magnetic resonance imaging magnet.

In another example, the method further comprises disabling powering of the magnetic resonance imaging magnet to perform an emergency discharge operation. This may be beneficial because the use of the energy recovery system enables power to be transferred from the driven magnetic resonance imaging magnet to the electrical power storage system fairly rapidly.

In another example, the method further comprises disabling powering of the driven magnetic resonance imaging magnet to conserve electrical power.

In another aspect, there is a computer program comprising machine-executable instructions for execution by a computational system controlling a magnetic resonance imaging magnet according to an example. Execution of the machine-executable instructions further causes the computational system to control the power management system to discharge the magnetic resonance imaging system to charge the electrical power storage system. Execution of the machine-executable instructions further causes the computational system to control the power supply to ramp up charging of the magnetic resonance imaging magnet at least partially using stored electrical power in the electrical power storage system.

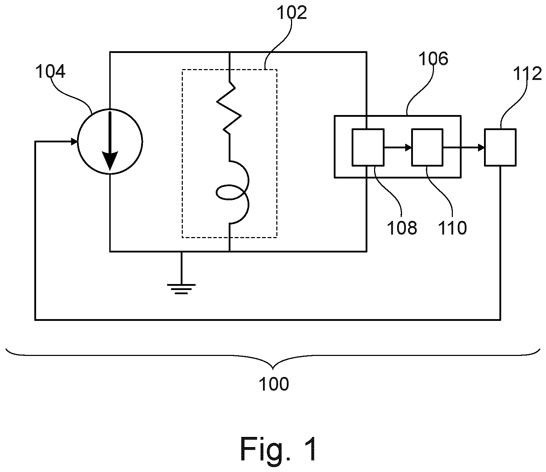

Fig. 1 illustrates an example of a power management system 100. The power management system 100 is shown as being connected to a magnetic resonance imaging magnet 102 that is represented by a resistance and inductance in series. The power management system 100 comprises a power supply 104 that is configured for ramping up or powering the magnetic resonance imaging magnet 102 during operation. In the cases where the magnetic resonance imaging magnet 102 is driven magnet, the power supply 104 is configured for continuously supplying a small amount of power to maintain the magnetic field in the magnetic resonance imaging magnet 102 during clinical operation, for example during imaging, during standby between imaging when intervals between subsequent imaging operations are below a predetermined duration. The power management system 100 is further shown as comprising an energy recovery system 106 that is able to regulate the discharge of the electrical power from the magnetic resonance imaging magnet 102. The energy recovery system 106 is then configured for charging the electric power of the magnetic resonance imaging magnet 102 into an electrical power storage system 112. The electrical power storage system 112 may comprise for example a flywheel and/or a battery system or battery and/or capacitors or supercapacitors. The electrical power storage system 112 is further shown as being connected to the power supply 104. For example, when it is desired to power down the magnet 102 the power supply 104 may be disengaged.

The energy recovery system 106 is then used to controllably discharge the magnet 102 and deposit at least a portion of the power into the electrical power storage system 112. When it is desired to again power up the magnet 102, the electrical power storage system 112 can be used to supply at least a portion of the power used to charge up the magnet 102.

The energy recovery system 106 is shown as having a controlled discharge path 108 that is connected to a DC-to-DC converter 110. The control discharge path 108 for example may be implemented using a number of MOSFET, IGBT, SiC, transistors, or gallium nitride transistors. In some examples the DC-to-DC converter 110 is a DC-to-DC converter from an automotive regenerative braking or KERS system.

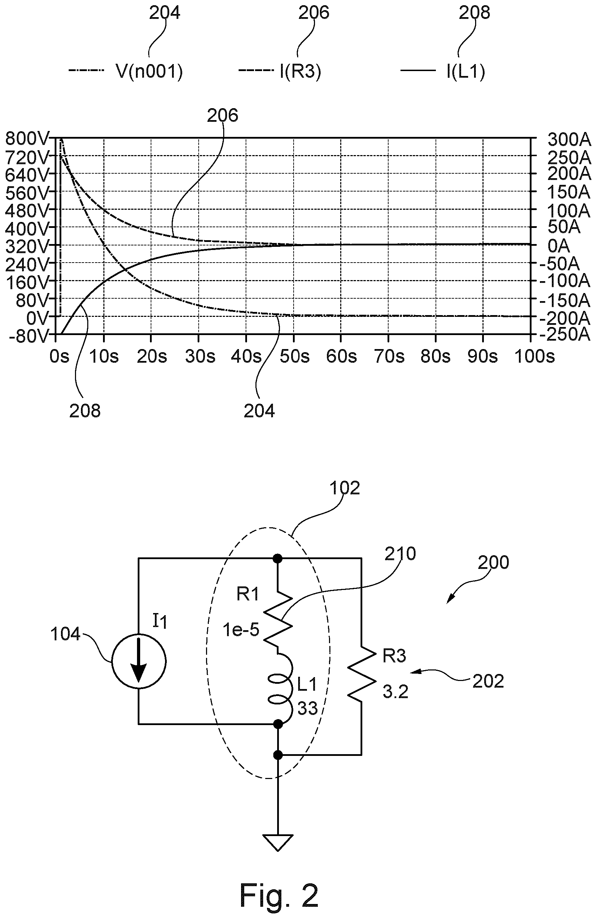

Figs. 2, 3, and 4 are used to illustrate some design considerations in designing a power management system 100. Fig. 2 shows a simplified discharge circuit 200 that uses an external resistor 202 to discharge the magnet 102.

In Fig. 2, a driven magnet (L1) is used. R1 210 is residual resistance and R3 202 is the dump resistor. Current source I1 104 drives a current through L1. The stored energy in L1 is about 1 MJ as a rule of thumb example. At t = 1s, the current source 104 stops providing current (e.g., by intentionally opening an internal switch, at a rap down time of the current of 1ms).

The voltage, i.e. electrical potential difference, over R1 210 and L1 instantly rises to 800 V and the current starts to run through R3 202. The instantaneous power over R3 is 200 kW! Furthermore, there is the intended drop of current through L1 at the moment when the power supply is switched off.

In this example, the ramp down time was adjusted to about 60 s. Above the simplified discharge circuit 200 is a plot which shows the voltage 204 over R1 and L1 as well as the currents through the external resistor 202 and the resistance 210 of the magnet 102.

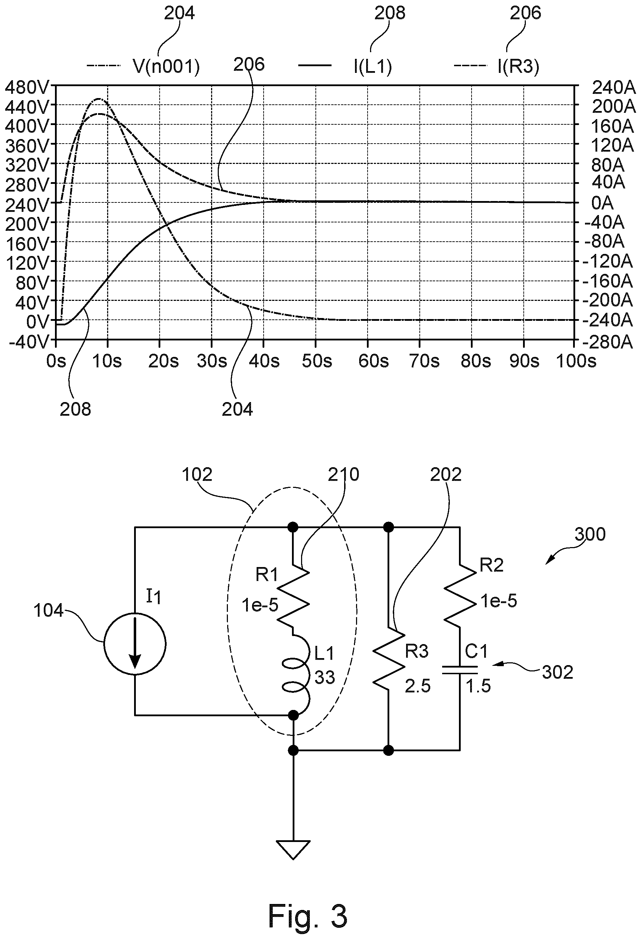

Fig. 3 shows another simplified discharge circuit 300 that uses a dump capacitor C1. The dump capacitor 302 is shown as being in parallel with the external resistor 202. The voltage 204, as well as the currents 206 and 208, are also shown as a function of time.

In this modified circuit, the voltage across R1 210 and L1 reduces nearly by a factor of 2 to 450 V. The rapid current drop in the moment of switching is flattened. The maximum instantaneous power in R3 is reduced to 80 kW.

The capacitor with a rating of 1.5 F and > 450 V can be realized practically, since next to typical capacitors (or capacitor banks) one can use Lithium or Sodium based batteries and capacitors to store the energy. In fact, a combination thereof is the most cost-effective solution for the required performance to be achieved.

Taking the car industry as a reference, charging voltages of in the order of 800 V are well established, charging currents reach at least the demands of our magnet. While in electric cars batteries reach capacitances of <40 kWh, our energy storage (when realized with Li ion batteries alone) requires only 42 Wh capacity.

R3 and C1 may be dimensioned such that a desired discharge time, such as 60 seconds, is reached. Considering the circuitry as parallel resonant circuitry, equations are straightforward. In the example, L1, R3 and C1 were selected close to the aperiodic (critically damped case), which allows "the circuit response that decays in the fastest possible time without going into oscillation." For example, using the equation:

$$R = 0.5 * sqrt(L1*C1) = 2.35 \text{ Ohm}.$$

It is also noted that an undesired reverse current through L1 (reverse magnetic field) does not occur in the aperiodic case.

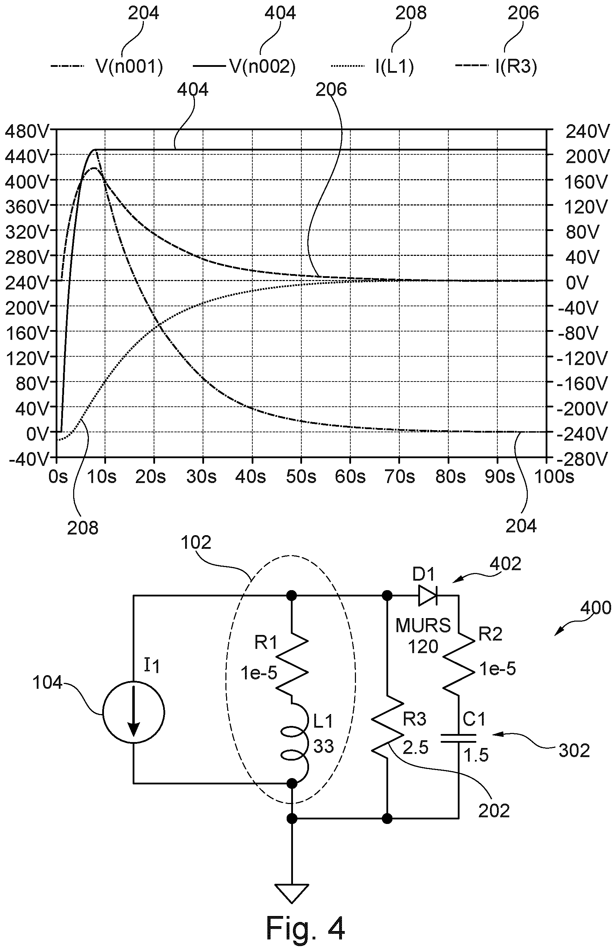

Fig. 4 illustrates a more complex discharge circuit 400. In this example there is additionally a diode 402 which prevents energy stored in the capacitor 302 being discharged through the resistor 202. In Fig. 4, the diode D1 402 prevents that energy stored in C1 302 during the process dissipates in R3. When designing a power management system 100 the circuit in Fig. 4 may be adapted. The electrical power storage system 112 may replace the capacitor C1302 and the energy recovery system may replace R3 202 and D1 402.

In the given example, the energy to be dissipated rapidly in R3 reduces by 15%, energy can be released in a controlled manner over a longer timeframe. The advantage of D1 can also be used for oscillating conditions R>0.5*sqrt(L1*C1). This enables faster ramp-down times while the diode prevents reverse currents (at the cost of higher voltage).

In the chart above the schematic circuit of Fig. 4, the voltages across the magnet 204 and across the capacitor C1404 are shown as well as the current through the magnet 208 and the current through the dump resistor is shown in curve 206. This shows that the current dissipated through the resistor 202 drops drastically and the voltage is maintained across the capacitor 302. The voltage across the capacitor C1 could for example be passed to a DC-to-DC converter 110 to power or charge an electrical power storage system 112.

With their high-power density, Lithium Ion Capacitors (LIC) may be a good choice for circuits where electric energy needs to be stored/released in a short fraction of time, just like recuperation storage of electric cars or the present application of storing energy from a magnetic resonance imaging magnet.

The higher power density in Lithium Ion capacitors is reached due to the about 50% reduced inner resistance of LIC vs. Lithium ion batteries with comparable capacitance. To reach the desired voltage range of hundreds of volts, one may put several capacitors in series. Some commercially available Lithium ion capacitors have up to 380 V operating voltage are reached at a then nominal capacitance of 1 F, the internal resistance is then 7.5 Ohm.

This is still low enough to cause a significant reduction of the voltage during magnet discharge, preventing arcing and excessive heating of the discharge unit.

To optimize an energy recovery system, one may additionally consider properties of the battery/capacitor chosen, requiring a dedicated charge controller between inductance L and storage unit, in which the properties of the discharging magnet are matched with the ideal bias point of the storage unit. Such systems for an energy recovery system can be used from the car industry. Automotive kinetic energy recovery systems typically handle up to 2 MJ of energy, at ratings of 500 V/1000 A within some seconds, at an efficiency of >95% meaning that only <5% of the energy is dissipated, differing from the examples given previously, wherein the majority of the power is dissipated in the dump resistor R3.

The challenge for MRI magnets is to operate the energy recovery system as close as possible to the magnet (low line losses), without being susceptible to strong static magnetic fields. This can be achieved by design means of the controller using non-magnetic parts, and/or by designing the whole system so that the controller and parts with necessarily magnetic components is placed at a position with low static magnetic field.

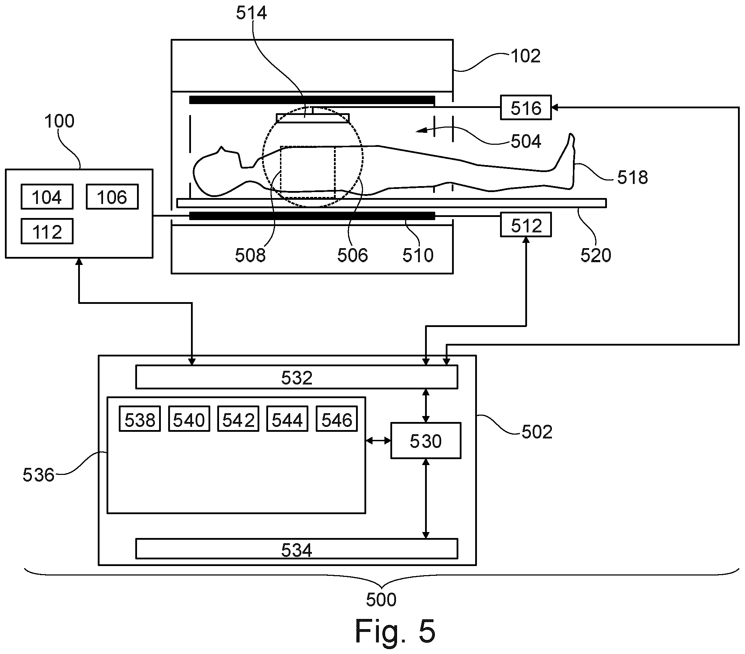

Fig. 5 illustrates an example of a magnetic resonance imaging system 500. The magnetic resonance imaging system 500 is shown as comprising a power management system 100 used for powering the magnetic resonance imaging magnet 102. The magnetic resonance imaging system 500 further comprises a computer 502, which is used to control the operation and function of the magnetic resonance imaging system 500.

The magnet 102 is a superconducting cylindrical type magnet with a bore 504 through it. It may be a driven magnet. It is also possible to use both a split cylindrical magnet and a so-called open magnet. A split cylindrical magnet is similar to a standard cylindrical magnet, except that the cryostat has been split into two sections to allow access to the iso-plane of the magnet, such magnets may for instance be used in conjunction with charged particle beam therapy. An open magnet has two magnet sections, one above the other with a space in-between that is large enough to receive a subject. The arrangement of the two sections area is similar to that of a Helmholtz coil. Open magnets are popular because the subject is less confined. Inside the cryostat of the cylindrical magnet there is a collection of superconducting coils.

Within the bore 504 of the cylindrical magnet 102 there is an imaging zone 506 where the magnetic field is strong and uniform enough to perform magnetic resonance imaging. A field of view 508 is shown within the imaging zone 506. The k-space data are acquired for the field of view 508. The region of interest could be identical with the field of view 508 or it could be a sub volume of the field of view 508. A subject 518 is shown as being supported by a subject support 520 such that at least a portion of the subject 518 is within the imaging zone 506 and the field of view 508.

Within the bore 504 of the magnet there is also a set of magnetic field gradient coils 510 which is used for the acquisition of measured k-space data to spatially encode magnetic spins within the imaging zone 506 of the magnet 102. The magnetic field gradient coils 510 are connected to a magnetic field gradient coil power supply 512. The magnetic field gradient coils 510 are intended to be representative. Typically, magnetic field gradient coils 510 contain three separate sets of coils for spatial encoding in three orthogonal spatial directions. A magnetic field gradient power supply supplies current to the magnetic field gradient coils. The current supplied to the magnetic field gradient coils 510 is controlled as a function of time and may be ramped or pulsed.

Adjacent to the imaging zone 506 is a radio frequency coil 514 for manipulating the orientations of magnetic spins within the imaging zone 506 and for receiving radio transmissions from spins also within the imaging zone 506. The radio frequency antenna may contain multiple coil elements. The radio frequency antenna may also be referred to as a channel or antenna. The radio frequency coil 514 is connected to a radio frequency transceiver 516. The radio frequency coil 514 and radio frequency transceiver 516 may be replaced by separate transmit and receive coils and a separate transmitter and receiver. It is understood that the radio frequency coil 514 and the radio frequency transceiver 516 are representative. The radio frequency coil 514 is intended to also represent a dedicated transmit antenna and a dedicated receive antenna. Likewise, the transceiver 516 may also represent a separate transmitter and receiver. The radio frequency coil 514 may also have multiple receive/transmit elements and the radio frequency transceiver 516 may have multiple receive/-transmit channels.

The computer 502 is shown as comprising a computational system 530. The computational system 530 is intended to represent one or more computational systems or computing cores located at one or more locations. The computational system 530 is further shown as being connected to a hardware interface 532 that enables the computational system 530 to communicate and control other components of the magnetic resonance imaging system 500. For example, the hardware interface 532 is shown as being connected to the power management system 100, the magnetic field gradient coil power supply 512, and the transceiver 516.

The computational system 530 is further shown as being connected to an optional user interface 534 that may for example be used by an operator or controller to operate the magnetic resonance imaging system 500. The computational system 530 is further shown as being connected to a memory 536. The memory 536 is intended to represent various types of memory which may be accessible to the computational system 530. The memory 536 may include volatile and non-volatile memory storage means and components. The memory in some embodiments may be based on or may rely on cloud-based data stored in logical pools across disparate, commodity storage servers located on premises or in a data center managed by a third-party cloud provider. Accordingly, the memory as schematically depicted in Fig. 5 is just for illustration purposes. Therefore, any or all components comprised in memory 536 may be cloud-based.

The memory 536 is shown as containing machine-executable instructions 538. The machine-executable instructions 538 enable the computational system 530 to control the various components of the magnetic resonance imaging system 500 as well as to perform basic numerical and image processing tasks such as reconstructing magnetic resonance images or performing other image processing.

The memory 536 is further shown as containing pulse sequence commands 540. The pulse sequence commands 540 are commands or data which may be converted into commands which control the magnetic resonance imaging system 500 according to a magnetic resonance imaging protocol. The memory 536 is further shown as containing k-space data 542 that was acquired by controlling the magnetic resonance imaging system 500 with the pulse sequence commands 540. The memory 536 is further shown as containing a magnetic resonance image 544 that was reconstructed from the k-space data 542. The memory 536 is further shown as containing a magnet scheduling program 546 that may, for example, be used for powering up and powering down the magnet 102 in order to conserve energy. The magnet 102 may be a conventional magnetic resonance imaging magnet, in other examples the magnet 102 may be a driven magnet.

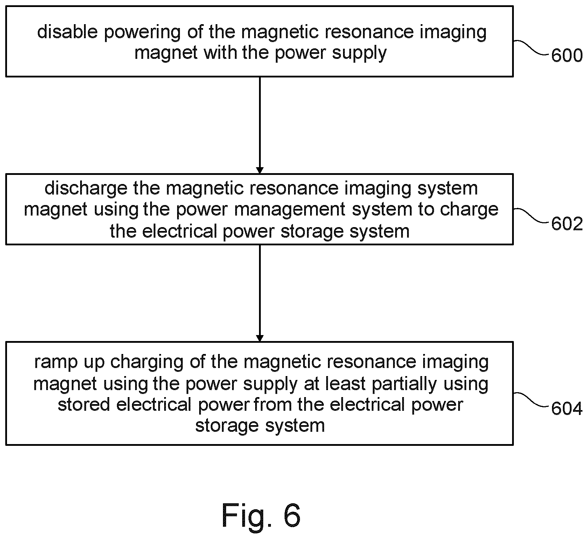

Fig. 6 shows a flowchart which illustrates a method of operating the magnet 102 using the power management system 100. Step 600 is optional. If the magnetic resonance imaging magnet 102 is a driven magnetic resonance imaging magnet then step 600 may be performed. In step 600 the powering of the magnetic resonance imaging magnet 102 is disabled. After step 600 is performed, the power supply 104 is no longer providing power to maintain the driven magnetic resonance imaging magnet 102. Steps 602 and 604 are performed regardless if the magnet 102 is a driven magnet or not. In step 602 the magnetic resonance imaging magnet 102 is discharged using the energy recovery system 106 to charge the electrical power storage system 112. After step 602, the magnetic resonance imaging magnet 102 has been ramped down. When it is desired to use the magnetic resonance imaging system 500, the magnet is then charged up again in step 604. In step 604, the charging of the magnetic resonance imaging magnet 102 is ramped up using the power supply 104 and at least partially using some of the stored electrical power in the electrical power storage system 112.

It is understood that one or more of the aforementioned examples or embodiments of the invention may be combined as long as the combined embodiments are not mutually exclusive.

As will be appreciated by one skilled in the art, aspects of the present invention may be embodied as an apparatus, method or computer program product. Accordingly, aspects of the present invention may take the form of an entirely hardware embodiment, an entirely software embodiment (including firmware, resident software, micro-code, etc.) or an embodiment combining software and hardware aspects that may all generally be referred to herein as a "circuit", "module" or "system." Furthermore, aspects of the present invention may take the form of a computer program product embodied in one or more computer readable medium(s) having computer executable code embodied thereon.

Any combination of one or more computer readable medium(s) may be utilized. The computer readable medium may be a computer readable signal medium or a computer readable storage medium. A 'computer-readable storage medium' as used herein encompasses any tangible storage medium which may store instructions which are executable by a processor or computational system of a computing device. The computer-readable storage medium may be referred to as a computer-readable non-transitory storage medium. The computer-readable storage medium may also be referred to as a tangible computer readable medium. In some embodiments, a computer-readable storage medium may also be able to store data which is able to be accessed by the computational system of the computing device. Examples of computer-readable storage media include, but are not limited to: a floppy disk, a magnetic hard disk drive, a solid state hard disk, flash memory, a USB thumb drive, Random Access Memory (RAM), Read Only Memory (ROM), an optical disk, a magneto-optical disk, and the register file of the computational system. Examples of optical disks include Compact Disks (CD) and Digital Versatile Disks (DVD), for example CD-ROM, CD-RW, CD-R, DVD-ROM, DVD-RW, or DVD-R disks. The term computer readable-storage medium also refers to various types of recording media capable of being accessed by the computer device via a network or communication link. For example, data may be retrieved over a modem, over the internet, or over a local area network. Computer executable code embodied on a computer readable medium may be transmitted using any appropriate medium, including but not limited to wireless, wire line, optical fiber cable, RF, etc., or any suitable combination of the foregoing.

A computer readable signal medium may include a propagated data signal with computer executable code embodied therein, for example, in baseband or as part of a carrier wave. Such a propagated signal may take any of a variety of forms, including, but not limited to, electro-magnetic, optical, or any suitable combination thereof. A computer readable signal medium may be any computer readable medium that is not a computer readable storage medium and that can communicate, propagate, or transport a program for use by or in connection with an instruction execution system, apparatus, or device.

'Computer memory' or 'memory' is an example of a computer-readable storage medium. Computer memory is any memory which is directly accessible to a computational system. 'Computer storage' or 'storage' is a further example of a computer-readable storage medium. Computer storage is any non-volatile computer-readable storage medium. In some embodiments computer storage may also be computer memory or vice versa.

A 'computational system' as used herein encompasses an electronic component which is able to execute a program or machine executable instruction or computer executable code. References to the computational system comprising the example of "a computational system" should be interpreted as possibly containing more than one computational system or processing core. The computational system may for instance be a multi-core processor. A computational system may also refer to a collection of computational systems within a single computer system or distributed amongst multiple computer systems. The term computational system should also be interpreted to possibly refer to a collection or network of computing devices each comprising a processor or computational systems. The machine executable code or instructions may be executed by multiple computational systems or processors that may be within the same computing device or which may even be distributed across multiple computing devices.

Machine executable instructions or computer executable code may comprise instructions or a program which causes a processor or other computational systems to perform an aspect of the present invention. Computer executable code for carrying out operations for aspects of the present invention may be written in any combination of one or more programming languages, including an object-oriented programming language such as Java, Smalltalk, C++ or the like and conventional procedural programming languages, such as the C programming language or similar programming languages and compiled into machine executable instructions. In some instances, the computer executable code may be in the form of a high-level language or in a pre-compiled form and be used in conjunction with an interpreter which generates the machine executable instructions on the fly. In other instances, the machine executable instructions or computer executable code may be in the form of programming for programmable logic gate arrays.

The computer executable code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a Local Area Network (LAN) or a Wide Area Network (WAN), or the connection may be made to an external computer (for example, through the Internet using an Internet Service Provider).

Aspects of the present invention are described with reference to flowchart illustrations and/or block diagrams of methods, apparatus (systems) and computer program products according to embodiments of the invention. It is understood that each block or a portion of the blocks of the flowchart, illustrations, and/or block diagrams, can be implemented by computer program instructions in form of computer executable code when applicable. It is further understood that, when not mutually exclusive, combinations of blocks in different flowcharts, illustrations, and/or block diagrams may be combined. These computer program instructions may be provided to a computational system of a general-purpose computer, special-purpose computer, or other programmable data processing apparatus to produce a machine, such that the instructions, which execute via the computational system of the computer or other programmable data processing apparatus, create means for implementing the functions/acts specified in the flowchart and/or block diagram block or blocks.

These machine executable instructions or computer program instructions may also be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or block diagram block or blocks.

The machine executable instructions or computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in the flowchart and/or block diagram block or blocks.

A 'user interface' as used herein is an interface which allows a user or operator to interact with a computer or computer system. A 'user interface' may also be referred to as a 'human interface device.' A user interface may provide information or data to the operator and/or receive information or data from the operator. A user interface may enable input from an operator to be received by the computer and may provide output to the user from the computer. In other words, the user interface may allow an operator to control or manipulate a computer and the interface may allow the computer to indicate the effects of the operator's control or manipulation. The display of data or information on a display or a graphical user interface is an example of providing information to an operator. The receiving of data through a keyboard, mouse, trackball, touchpad, pointing stick, graphics tablet, joystick, gamepad, webcam, headset, pedals, wired glove, remote control, and accelerometer are all examples of user interface components which enable the receiving of information or data from an operator.

A 'hardware interface' as used herein encompasses an interface which enables the computational system of a computer system to interact with and/or control an external computing device and/or apparatus. A hardware interface may allow a computational system to send control signals or instructions to an external computing device and/or apparatus. A hardware interface may also enable a computational system to exchange data with an external computing device and/or apparatus. Examples of a hardware interface include but are not limited to: a universal serial bus, IEEE 1394 port, parallel port, IEEE 1284 port, serial port, RS-232 port, IEEE-488 port, Bluetooth connection, WLAN connection, TCP/IP connection, Ethernet connection, control voltage interface, MIDI interface, analog input interface, and digital input interface.

A 'display' or 'display device' as used herein encompasses an output device or a user interface adapted for displaying images or data. A display may output visual, audio, and or tactile data. Examples of a display include, but are not limited to: a computer monitor, television screen, touch screen, tactile electronic display, Braille screen, Cathode Ray Tube (CRT), storage tube, bistable display, electronic paper, vector display, flat panel display, Vacuum Fluorescent (VD) display, Light-Emitting Diode (LED) displays, Electro-Luminescent Display (ELD), Plasma Display Panels (PDP), Liquid Crystal Display (LCD), Organic Light-Emitting Diode (OLED) displays, a projector, and head-mounted display.

While the invention has been illustrated and described in detail in the drawings and foregoing description, such illustration and description are to be considered illustrative or exemplary and not restrictive; the invention is not limited to the disclosed embodiments.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measures cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

REFERENCE SIGNS LIST

| | |
|---|---|
| 100 | power management system |
| 102 | magnetic resonance imaging magnet |
| 104 | power supply |
| 106 | energy recovery system |
| 108 | controlled discharge path |
| 110 | DC-to-DC converter |
| 112 | electrical power storage system |
| 200 | simplified discharge circuit |
| 202 | simple load resistor (R3) |

204    voltage across magnet (R1)
206    current through load resistor (R3)
208    current through magnet (L1)
300    simplified discharge circuit with dump capacitor
302    dump capacitor (C1)
400    more sophisticated discharge circuit
402    diode
500    magnetic resonance imaging system
502    computer
504    bore of magnet
506    imaging zone
508    field of view
510    magnetic field gradient coils
512    magnetic field gradient coil power supply
514    radio frequency coil
516    transceiver
518    subject
520    subject support
530    computational system
532    hardware interface
534    user interface
536    memory
538    machine executable instructions
540    pulse sequence commands
542    k-space data
544    magnetic resonance image
546    magnet scheduling program
600    disable powering of the magnetic resonance imaging magnet with the power supply
602    discharge the magnetic resonance imaging system magnet using the power management system to charge the electrical power storage system
604    ramp up charging of the magnetic resonance imaging magnet using the power supply at least partially using stored electrical power in the electrical power storage system

**Claims**

1. A power management system (100) for a magnetic resonance imaging magnet (102) comprising:

   - a power supply (104) configured for powering the magnetic resonance imaging magnet;
   - an electrical power storage system (112); and
   - an energy recovery system (106) configured for discharging electrical power from the magnetic resonance imaging magnet and storing the electrical power in the electrical power storage system when the power supply ceases powering the magnetic resonance imaging magnet, and wherein the power management system is further configured for at least partially powering the magnetic resonance imaging magnet using the electrical power storage system.

2. The power management system of claim 1, wherein the power supply is configured for continually powering a driven magnetic resonance imaging magnet during clinical operation, wherein the power management system is configured for discharging electrical power from the magnetic resonance imaging magnet and storing the electrical power in the electrical power storage system when the power supply ceases powering the magnetic resonance imaging magnet, wherein preferably, the driven magnetic resonance imaging magnet is a sealed magnetic resonance imaging magnet.

3. The power management system of claim 1 or 2, wherein the energy recovery system comprises:

   - a controlled discharge path (108) configured for regulating the discharge of the electrical power; and
   - a DC-to-DC converter system (110) configured for charging the electrical power storage system using the regulated electrical power.

4. The power management system of claim 3, wherein the energy recovery system is configured to discharge the magnetic resonance imaging magnet within 120 seconds using the controlled discharge path and the DC-to-DC converter system, and wherein preferably, the energy recovery system is configured to discharge the magnetic resonance imaging magnet within 60 seconds using the controlled discharge path and the DC-to-DC converter system.

5. The power management system of claim 3 or 4, wherein the DC-to-DC converter system comprises an automotive regenerative breaking or kinetic energy recovery system.

6. The power management system of any of the claims 3 to 5, wherein the DC-to-DC converter is bidirectional and is configured for at least partially powering the power supply using the electrical power storage system.

7. The power management system of any of the claims 3 to 6, wherein the controlled discharge path is implemented using any one of the following: MOSFETs, IGBTs, SiC transistors, GaAs transistors, GaN transistors, and combinations thereof.

8. The power management system of any one of the preceding claims, wherein the electrical power storage system comprises a flywheel energy storage system, wherein the flywheel energy storage system is preferably an automotive flywheel energy storage system.

9. The power management system of any one of the preceding claims,

    - wherein the electrical power storage system comprises a super capacitor energy storage system, wherein preferably the super capacitor energy storage system comprises at least one Lithium ion capacitor; and/or
    - wherein the electrical power storage system is configured to transfer electrical power to an electrical grid.

10. The power management system of any one of the preceding claims, wherein the electrical power storage system comprises a battery system, wherein the battery storage system preferably comprises any one of the following: at least one Lithium ion battery, at least one lead acid battery, at least one Sodium battery, and combinations thereof.

11. A magnetic resonance imaging magnet (102) comprising the power management system (100) of any one of the preceding claims.

12. A magnetic resonance imaging system (500) comprising the magnetic resonance imaging magnet (102) of claim 11.

13. A method of operating a magnetic resonance imaging magnet (102), comprising:

    - discharging (602) the magnetic resonance imaging magnet using an energy recovery system to charge an electrical power storage system; and
    - ramping (604) up charging of the magnetic resonance imaging at least partially using stored electrical power in the electrical power storage system.

14. The method of claim 13, wherein a power supply is configured for continually powering a driven magnetic resonance imaging magnet during clinical operation, wherein the method further comprises disabling (600) powering of the driven magnetic resonance imaging magnet with the power supply before discharging the driven magnetic resonance imaging magnet,
wherein preferably, the method comprises any one of the following:

    - disabling powering of the driven magnetic resonance imaging magnet to perform an emergency discharge operation; and
    - disabling powering of the driven magnetic resonance imaging magnet to conserve electrical power.

15. A computer program comprising machine executable instructions (538) for execution by a computational system (530) controlling a magnetic resonance imaging magnet (102), wherein execution of the machine executable instructions further causes the computational system to:

    - control (602) an energy recovery system (100) to discharge the magnetic resonance imaging magnet (102) for charging an electrical power storage system (112); and
    - control (604) ramping up charging of the magnetic resonance imaging magnet at least partially using stored electrical power in the electrical power storage system.

Fig. 1

Fig. 2

Fig. 3

Fig. 4

Fig. 5

EP 4 745 609 A1

```
┌─────────────────────────────────────────────┐
│  disable powering of the magnetic resonance  │
│      imaging magnet with the power supply     │───600
└─────────────────────────────────────────────┘
                      │
                      ▼
┌─────────────────────────────────────────────┐
│   discharge the magnetic resonance imaging   │
│  system magnet using the power management     │───602
│  system to charge the electrical power        │
│                storage system                 │
└─────────────────────────────────────────────┘
                      │
                      ▼
┌─────────────────────────────────────────────┐
│   ramp up charging of the magnetic resonance  │
│  imaging magnet using the power supply at     │
│  least partially using stored electrical      │───604
│  power from the electrical power              │
│                storage system                 │
└─────────────────────────────────────────────┘
```

## Fig. 6

Europäisches
Patentamt

European
Patent Office

Office européen
des brevets

## EUROPEAN SEARCH REPORT

**Application Number**

EP 24 21 2876

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2022/244332 A1 (STAINSBY JEFF ALAN [CA] ET AL) 4 August 2022 (2022-08-04) | 1,2, 10-15 | INV. G01R33/3815 |
| Y | * paragraphs [0017], [0041], [0054] - [0057]; figures 1, 2 * ----- | 3-9 | |
| Y | US 2024/125877 A1 (TWIEG MICHAEL [US]) 18 April 2024 (2024-04-18) | 3-9 | |
| A | * paragraphs [0068], [0084]; figures 1, 2B, 3C, 4 * ----- | 1,2, 10-15 | |
| A | US 2013/147485 A1 (YOKOI MOTOHISA [JP]) 13 June 2013 (2013-06-13) * paragraphs [0053], [0074], [0085] - [0087] * ----- | 1-15 | |

**TECHNICAL FIELDS SEARCHED (IPC)**

G01R

The present search report has been drawn up for all claims

| Place of search | Date of completion of the search | Examiner |
|---|---|---|
| Munich | 11 April 2025 | Ó Donnabháin, C |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons
.....................................................................................
& : member of the same patent family, corresponding
    document

EPO FORM 1503 03.82 (P04C01)

**EP 4 745 609 A1**

## ANNEX TO THE EUROPEAN SEARCH REPORT
## ON EUROPEAN PATENT APPLICATION NO.

EP 24 21 2876

This annex lists the patent family members relating to the patent documents cited in the above-mentioned European search report.
The members are as contained in the European Patent Office EDP file on
The European Patent Office is in no way liable for these particulars which are merely given for the purpose of information.

11-04-2025

| Patent document cited in search report | Publication date | Patent family member(s) | Publication date |
|---|---|---|---|
| US 2022244332 A1 | 04-08-2022 | NONE | |
| US 2024125877 A1 | 18-04-2024 | CN 116368394 A | 30-06-2023 |
| | | EP 4211481 A1 | 19-07-2023 |
| | | TW 202216059 A | 01-05-2022 |
| | | US 2022075015 A1 | 10-03-2022 |
| | | US 2024125877 A1 | 18-04-2024 |
| | | WO 2022055808 A1 | 17-03-2022 |
| US 2013147485 A1 | 13-06-2013 | CN 103156607 A | 19-06-2013 |
| | | JP 2013144099 A | 25-07-2013 |
| | | US 2013147485 A1 | 13-06-2013 |

For more details about this annex : see Official Journal of the European Patent Office, No. 12/82